# EUROPÄISCHE PATENTSCHRIFT

(11) **EP 2 893 603 B1**
(45) Veröffentlichungstag und Bekanntmachung des Hinweises auf die Patenterteilung: **20.11.2019**
(21) Anmeldenummer: 13742463.6
(22) Anmeldetag: 31.07.2013
(51) Int. Cl.: H02H 7/10, H02H 7/125, H02M 3/156, H02M 3/158, H02J 7/14, H03K 17/16, H02H 7/06, H02M 7/219, H02M 1/32

(54) **VERFAHREN ZUR ANSTEUERUNG EINES AKTIVEN BRÜCKENGLEICHRICHTERS BEI LASTABWURF, GLEICHRICHTERANORDNUNG UND COMPUTERPROGRAMMPRODUKT**
METHOD FOR DRIVING AN ACTIVE BRIDGE RECTIFIER IN THE EVENT OF LOAD DUMP, RECTIFIER ARRANGEMENT AND COMPUTER PROGRAM PRODUCT
PROCÉDÉ DE COMMANDE D'UN REDRESSEUR EN PONT ACTIF LORS D'UN DÉLESTAGE, SYSTÈME REDRESSEUR ET PRODUIT LOGICIEL INFORMATIQUE

(30) Priorität: 03.09.2012 DE 102012215561
(43) Veröffentlichungstag der Anmeldung: 15.07.2015
(73) Patentinhaber: SEG Automotive Germany GmbH, 70499 Stuttgart (DE)
(72) Erfinder: OTTE, Christopher, 72762 Reutlingen (DE); MEHRINGER, Paul, 70569 Stuttgart (DE)
(74) Vertreter: Steinbauer, Florian
(86) Internationale Anmeldenummer: PCT/EP2013/066079
(87) Internationale Veröffentlichungsnummer: WO 2014/032894

(56) Entgegenhaltungen:
- EP-A2- 1 443 623
- DE-A1-102009 046 955
- DE-U1- 20 309 792
- US-A1- 2007 236 194
- US-A1- 2007 279 106

## Beschreibung

Die vorliegende Erfindung betrifft ein Verfahren zur Ansteuerung eines Brückengleichrichters mit aktiven Schaltelementen bei Lastabwurf, eine zur Durchführung eines derartigen Verfahrens eingerichtete Gleichrichteranordnung sowie ein Computerprogrammprodukt.

### Stand der Technik

Zur Speisung von Gleichstromsystemen aus Drehstromsystemen können Gleichrichter unterschiedlicher Bauart eingesetzt werden. Die vorliegende Anmeldung betrifft dabei aktive bzw. gesteuerte Brückengleichrichter, die aktive Schaltelemente, beispielsweise in Form von bekannten Metall-Oxid-Halbleiter-Feldeffekttransistoren (MOSFETs) aufweisen. In Kraftfahrzeugbordnetzen werden in Entsprechung zu den dort üblicherweise verbauten Drehstromgeneratoren häufig Brückengleichrichter in sechspulsiger Ausführung verwendet. Die Erfindung eignet sich jedoch in gleicher Weise für Brückengleichrichter für andere Phasenzahlen, z.B. für fünfphasige Generatoren, und in anderen Einsatzszenarien.

Wie beispielsweise in der DE 10 2009 046 955 A1 erläutert, ist der Einsatz von aktiven Brückengleichrichtern in Kraftfahrzeugen unter anderem deshalb wünschenswert, weil diese im Gegensatz zu passiven bzw. ungesteuerten Brückengleichrichtern geringere Verlustleistungen aufweisen.

Ein kritischer Fehlerfall insbesondere bei aktiven Brückengleichrichtern ist jedoch der Lastabwurf (engl. Load Dump). Dieser tritt dann auf, wenn sich bei hoch erregtem Generator und einem entsprechend hohen abgegebenen Strom die Last am Generator (z.B. durch Abschalten von Verbrauchern) schlagartig verringert und dies nicht durch kapazitiv wirkende Elemente im Gleichspannungsnetz (z.B. die Batterie im Kraftfahrzeugbordnetz) abgefangen wird.

Hierbei kann durch den Generator im Extremfall bis zu einer Dauer von ca. 300 bis 500 ms weiterhin Energie ins Netz geliefert werden. Diese muss im Brückengleichrichter umgesetzt (gelöscht) werden können, um nachgeschaltete elektrische Komponenten vor Überspannungsschäden zu schützen. Dieser Schutz erfolgt bei passiven bzw. ungesteuerten Brückengleichrichtern in der Regel durch die Gleichrichterdioden selbst, weil dort die Verlustenergie in Wärme umgesetzt werden kann. In derzeit erhältlichen aktiven Schaltelementen, beispielsweise MOSFETs, lassen sich diese Eigenschaften jedoch nicht vollständig nachbilden. Daher sind zusätzliche Schutzstrategien erforderlich.

Bei einem Lastabwurf können beispielsweise einige oder alle Schaltelemente des oberen oder unteren Gleichrichterzweigs ganz oder zeitweise kurzgeschlossen werden, wie auch beispielsweise in der erwähnten DE 10 2009 046 955 A1 diskutiert. Ein entsprechendes Ansteuersignal kann dabei derart getaktet werden, dass ein minimales Spannungsniveau nicht unterschritten und ein maximales Spannungsniveau nicht überschritten wird.

Eine mehrfache Taktung des Ansteuersignals innerhalb einer Halbwelle hat jedoch Nachteile, weil hierzu eine Auswerteschaltung für jede Phase erforderlich und zur Aufrechterhaltung der Bordnetzspannung eine entsprechende Zwischenkreiskapazität vorzusehen ist. Dies ist aufgrund der thermischen Randbedingungen und der erforderlichen Schüttelfestigkeit am Anbauort am Generator nur schwer realisierbar. Insbesondere können bei einer Trennung entsprechender Phasenkurzschlüsse aber auch schnelle Stromänderungen auftreten, die in Kombination mit den vorhandenen Leitungsinduktivitäten zu Spannungsspitzen führen. Hierdurch können angebundene Komponenten beschädigt werden.

Gemäß US 2007/236194 werden Schaltflanken generell abgeflacht, d.h. die Schaltzeit wird systematisch verringert und nicht infolge eines Lastabwurfs angepasst.

Gemäß EP 1 443 623 wird bei Lastabwurf bzw. Überspannung am Ausgang eines Brückengleichrichters der in der oberen Halbbrücke eines Brückenzweiges enthaltene Schalter geöffnet, so dass in dieser Halbbrücke nur noch die parallele Diode leitet, wobei der Schalter der unteren Halbbrücke geschlossen wird bzw. bleibt, so dass der positive Anteil einer Phasenspannung nach Masse kurzgeschlossen wird (vgl. § [22]).

Bei US 2007/279106 werden leitungsgebundene und abgestrahlte Störungen beim Abschalten eines Leistungsschalter durch eine Clamp-Schaltung vermindert.

Bei DE 203 09 792 U1 werden Überspannungen an einem Lastschalter beim Abschalten einer induktiven Last durch Verzögern und Abflachen der Abschaltflanke verhindert. Es besteht daher weiterhin der Bedarf nach verbesserten Schutzstrategien für aktive Brückengleichrichter bei Lastabwurf.

### Offenbarung der Erfindung

Vor diesem Hintergrund schlägt die vorliegende Erfindung ein Verfahren zur Ansteuerung eines Brückengleichrichters mit aktiven Schaltelementen bei Lastabwurf, eine zur Durchführung eines derartigen Verfahrens eingerichtete Gleichrichteranordnung sowie ein Computerprogrammprodukt mit den Merkmalen der unabhängigen Patentansprüche vor.

### Vorteile der Erfindung

Ein wesentlicher Aspekt der vorliegenden Erfindung besteht darin, zur Ansteuerung zumindest eines aktiven Schaltelements eines Brückengleichrichters bei Lastabwurf ein Spannungssignal als Ansteuersignal zu verwenden, das zumindest eine im Vergleich zum normalen Betrieb verlängerte Schaltzeit aufweist. Unter einer "Schaltzeit" sei dabei im Rahmen dieser Anmeldung eine Zeit verstanden, die verstreicht, bis ein Ansteuersignal ausgehend von einem ersten, niedrigeren Spannungswert auf einen zweiten, höheren Spannungswert angestiegen oder von dem zweiten, höheren Spannungswert auf den ersten, niedrigeren Spannungswert abgesunken ist, sich also entsprechend (in einer der beiden Richtungen) verändert hat. Im Rahmen der Erfindung wird somit die Steigung des Ansteuersignals verändert.

Das zumindest eine aktive Schaltelement wird bei Lastabwurf dazu verwendet, ein anliegendes Spannungssignal zumindest zeitweise nach Masse durchzusteuern (also, wie erläutert, "kurzzuschließen"). In derartigen Phasen wird ein verwendetes aktives Schaltelement angesteuert, d.h. mit einem Ansteuersignal beaufschlagt, dessen Spannungswert ausreicht, um über das zumindest eine aktive Schaltelement eine Verbindung zwischen den schaltbaren Anschlüssen des aktiven Schaltelements, beispielsweise nach Masse, herzustellen. Bei einem entsprechenden Ansteuersignal handelt es sich beispielsweise um ein an ein Gate eines aktiven Schaltelements des Brückengleichrichters, z.B. eines MOSFETs, angelegtes Spannungssignal. Die schaltbaren Anschlüssen des aktiven Schaltelements sind beispielsweise dessen Drain- und Source-Anschluss.

Neben Transistoren eignen sich jedoch auch andere aktive Schaltelemente zur Verwendung im Rahmen der Erfindung, vorausgesetzt, dass sich durch eine Ansteuerung mit unterschiedlichen Spannungswerten zwischen dem ersten und dem zweiten Spannungswert unterschiedliche Widerstandswerte zwischen entsprechenden Schaltanschlüssen, die durch das aktive Schaltelement schaltbar sind, erzeugt werden können. Beispielsweise kann wenigstens ein aktives Schaltelement verwendet werden, bei dem eine Ansteuerung, die eine graduelle Einstellung der Spannungswerte zwischen dem ersten und dem zweiten Spannungswert umfasst, mit einer graduellen Veränderung des Durchlasswiderstands zwischen den Schaltanschlüssen (beispielsweise linear oder in Form einer mathematischen oder empirisch ermittelbaren Funktion) in Beziehung steht.

Wie allgemein bekannt, richtet sich der Durchlasswiderstand zwischen Drain und Source bei Transistoren, wie beispielsweise den erwähnten MOSFETs, nach der zwischen Gate und Source anliegenden Spannung. Unterhalb einer sogenannten Schwellenspannung (engl. Threshold Voltage) ist die Verbindung zwischen Drain und Source über den Transistor hochohmig, oberhalb dieser niederohmig.

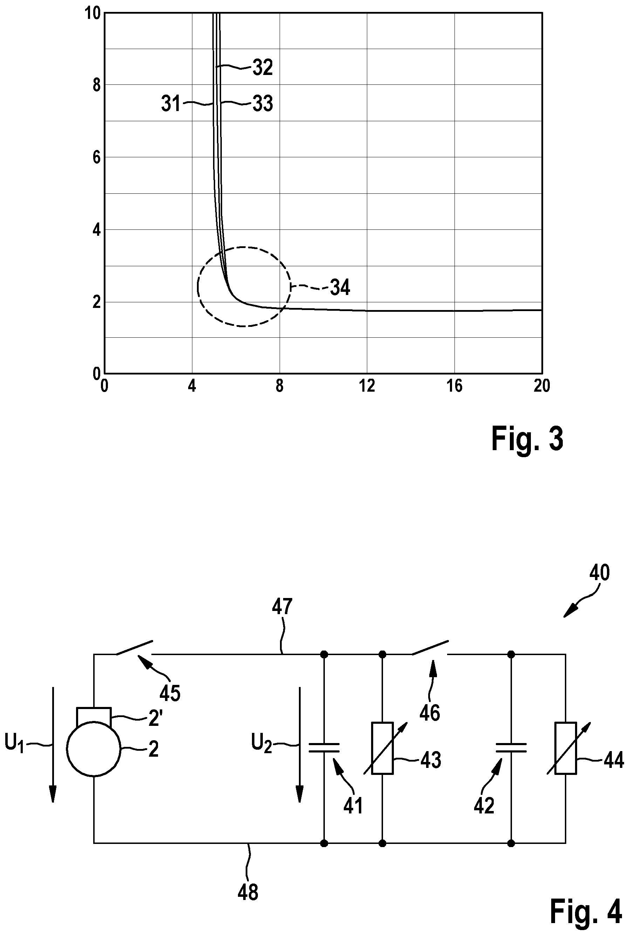

Der Durchlasswiderstand fällt bei Erreichen der Schwellenspannung jedoch nicht schlagartig auf seinen Minimalwert, bei dem dieser entsprechend dem gängigen Sprachgebrauch "durchgesteuert" ist. Dies ist auch unten in Zusammenhang mit Figur 4 veranschaulicht. Vielmehr bricht der Widerstand bei einer Erhöhung der Spannung zwischen Gate und Source über die Schwellenspannung zwar zunächst stark ein, jedoch nur auf einen bestimmten Wert oberhalb seines Minimalwerts. Erst wenn die am Gate anliegende Spannung weiter erhöht wird, beispielsweise um 1 bis 2 V, stellt sich der minimale Durchlasswiderstand ein.

Der erwähnte erste, niedrigere Spannungswert des Ansteuersignals zur Ansteuerung des zumindest einen aktivem Schaltelements des aktiven Brückengleichrichters bei Lastabwurf liegt daher vorzugsweise knapp (z.B. 0,1 V) unterhalb der Schwellenspannung, der zweite, höhere Spannungswert oberhalb dieser, und zwar bei einem Wert, bei dem der Durchlasswiderstand nahe seinem Minimalwert liegt. Der zweite, höhere Spannungswert kann beispielsweise 0,1 bis 2 V oberhalb des Durchlasswiderstands liegen.

Mit anderen Worten wird vorgeschlagen, ein Ansteuersignal zu verwenden, bei dem ein spezifischer Spannungsbereich zwischen einer ersten, niedrigeren Spannung (z.B. der Schwellenspannung) und einer zweiten, höheren Spannung (z.B. der Spannung, bei der der Transistor durchgesteuert ist) in beiden Richtungen nicht schneller als in einer spezifischen, vorgegebenen Zeitdauer durchlaufen wird. Die erste, niedrigere Spannung und die zweite, höhere Spannung können beispielsweise auf Grundlage von Herstellerangaben und/oder durch Messungen festgestellt werden. Beispielsweise wird die erste, niedrigere Spannung durch den Hersteller als Schwellenspannung, die zweite, höhere Spannung als "RDS_on" oder in Form eines vergleichbaren Werts angegeben.

Dieser Ansteuerung liegt also die Überlegung zugrunde, dass sich bei einer entsprechend langsameren Spannungsänderung in dem genannten Bereich der Durchlasswiderstand zwischen Drain und Source nur langsam ändert. Dies ist insbesondere beim Übergang von der zweiten, höheren Spannung auf die erste, niedrigere Spannung vorteilhaft. Bei einer entsprechenden Ansteuerung wird ein Stromfluss durch das jeweilige Schaltelement, und damit ein Kurzschluss, letztlich unterbrochen und ein Strom stattdessen in das an den Gleichrichter angebundene Gleichspannungsnetz eingespeist. Bei einem Übergang von der ersten, niedrigeren Spannung auf die zweite, höhere Spannung wird der Kurzschluss entsprechend aktiviert.

Wird bei einem Lastabwurf der genannte Bereich jeweils langsamer durchlaufen, wird der Durchlasswiderstand statt wie bisher schlagartig nunmehr allmählich verändert. In der Zeit, in der sich der Durchlasswiderstand verändert, kann sich z.B. der in den Leitungsinduktivitäten gespeicherte Strom abbauen, ohne dass deutliche Überspannungen (beim Lösen des Kurzschlusses) oder Unterspannungen (bei der Aktivierung des Kurzschlusses) auftreten. Hierdurch werden solche Über- oder Unterspannungen sicher vermieden.

Das erfindungsgemäße Ansteuerschema ist dabei naturgemäß besonders vorteilhaft bei dem erwähnten Übergang von der zweiten, höheren Spannung auf die erste, niedrigere Spannung, also beim Lösen des Kurzschlusses. Bei einer herkömmlichen Ansteuerung können die vorhandenen Induktivitäten den über die Schaltelemente in diesem Fall eingespeisten Strom zunächst häufig nicht aufnehmen, so dass die Spannung steigt. Auch beim Übergang von der ersten, niedrigeren Spannung auf die zweite, höhere Spannung (also bei der Aktivierung des Kurzschlusses) ergeben sich bei Anwendung des erfindungsgemäßen Verfahrens Vorteile. In diesem Fall werden Unterspannungen vermieden. Spannungsspitzen oder -einbrüche werden damit durch das erfindungsgemäße Verfahren insgesamt weitgehend vermieden und können z.B. direkt am Gleichrichter angebaute Elektroniken, wie z.B. Regler, nicht mehr schädigen.

Die genannte spezifische Zeitdauer kann beispielsweise auf Grundlage der Gleichung *U*_{L} = *L* × di/dt ermittelt werden. *U*_{L} bezeichnet die induzierte Spannung an der vorhandenen Zuleitungsinduktivität und gibt damit den erlaubten Spannungsversatz zwischen der Nenn- bzw. Sollspannung des Gleichspannungsnetzes und der Spannung am Gleichspannungsausgang des Brückengleichrichters (B+) wieder. Für eine maximal erlaubte induzierte Spannung *U*_{L} von beispielsweise 6 V und einer gegebenen Zuleitungsinduktivität von 1,5 µH darf der Stromanstieg nicht mehr als 4 A/µs betragen.

Ferner ist vorteilhafterweise dafür Sorge zu tragen, dass eine Unterbrechung eines Phasenkurzschlusses an mehreren Schaltelementen nicht gleichzeitig erfolgt. Hierzu werden geeignete Zeitbeträge als Puffer eingestellt. Hierdurch werden die einzelnen Phasenströme versetzt freigegeben, was den induzierten Spannungsanstieg in der Zuleitung zusätzlich begrenzt. Für einen entsprechenden Versatz kann bisweilen auch schon ausreichend sein, wenn der Beginn der einzelnen Ansteuerungen mit der erfindungsgemäß verlängerten Schaltzeit z.B. aufgrund von Toleranzen in Erkennungsschwellen zu versetzten Zeitpunkten erfolgt. In anderen Fällen können hierfür beispielsweise bekannte Zeitglieder eingesetzt werden.

Wie auch unten ausführlich erläutert, kann zur erfindungsgemäß verlangsamten Ansteuerung, also z.B. zur Erzeugung einer entsprechenden Spannungsrampe für das Ein- bzw. Ausschalten des Schaltelements, im einfachsten Fall ein RC-Glied verwendet werden. Auch andere Konzepte zur Erzeugung einer verlängerten Schaltzeit sind denkbar.

Die Erfindung bietet eine Reihe von Vorteilen gegenüber herkömmlichen Verfahren. Beispielsweise wurde vorgeschlagen, bei Lastabwurf aktive Schaltelemente, beispielsweise MOSFETs, durch eine externe Beschaltung in einen linearen Betriebsfall zu bringen und damit ein Systemverhalten zu erzeugen, das den bekannten Zenerdioden entspricht. Allerdings muss in den leistungselektronischen Bauelementen in diesem Betriebsfall eine hohe elektrische Verlustleistung umgesetzt werden. Erfindungsgemäß treten hingegen nur vergleichsweise geringe elektrische Verlustleistungen auf. Die Schaltelemente können daher weniger robust ausgelegt werden, was Kosten spart.

Auch gegenüber den eingangs erläuterten Verfahren, bei denen zur Löschung der bei einem Lastabwurf freiwerdenden Energie vorgesehen ist, einige oder alle Schaltelemente ganz oder zeitweise kurzzuschließen, bietet die Erfindung Vorteile. Insbesondere ist erfindungsgemäß keine zur Aufrechterhaltung der Bordnetzspannung herkömmlicherweise erforderliche, eng angebundene Zwischenkreiskapazität notwendig. Wie eingangs erwähnt, kann eine entsprechende Zwischenkreiskapazität am Anbauort am Generator aufgrund der thermischen Randbedingungen und der erforderlichen Schüttelfestigkeit allenfalls unter beträchtlichem Aufwand angebracht werden.

Insbesondere werden aufgrund der erfindungsgemäß vorgeschlagenen Maßnahmen jedoch bei der Freigabe von Phasenkurzschlüssen auftretende rasche Stromänderungen, und damit Spannungsspitzen, deutlich reduziert bzw. völlig vermieden. Nachgeschaltete Komponenten müssen daher nicht mit einem entsprechend aufwendigen Überspannungsschutz ausgestattet werden.

Eine erfindungsgemäße Recheneinheit, z.B. ein Steuergerät eines Kraftfahrzeugs oder eine Gleichrichtersteuerung, ist, insbesondere programmtechnisch, dazu eingerichtet, ein erfindungsgemäßes Verfahren durchzuführen.

Auch die Implementierung des Verfahrens in Form von Software ist vorteilhaft, da dies besonders geringe Kosten verursacht, insbesondere wenn ein ausführendes Steuergerät noch für weitere Aufgaben genutzt wird und daher ohnehin vorhanden ist. Geeignete Datenträger zur Bereitstellung des Computerprogramms sind insbesondere Disketten, Festplatten, Flash-Speicher, EEPROMs, CD-ROMs, DVDs u.a.m. Auch ein Download eines Programms über Computernetze (Internet, Intranet usw.) ist möglich.

Weitere Vorteile und Ausgestaltungen der Erfindung ergeben sich aus der Beschreibung und der beiliegenden Zeichnung.

Es versteht sich, dass die vorstehend genannten und die nachfolgend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand eines Ausführungsbeispiels in der Zeichnung schematisch dargestellt und wird im Folgenden unter Bezugnahme auf die Zeichnung ausführlich beschrieben.

### Kurze Beschreibung der Zeichnungen

- Figur 1: zeigt eine Anordnung mit einem aktiven Brückengleichrichter, der erfindungsgemäß angesteuert werden kann, in schematischer Darstellung.
- Figur 2: zeigt einen Stromverlauf bei Ansteuerung eines aktiven Brückengleichrichters bei Lastabwurf gemäß dem Stand der Technik.
- Figur 3: zeigt Kennlinien eines gemäß einer Ausführungsform der Erfindung ansteuerbaren aktiven Schaltelements in einem aktiven Brückengleichrichter.
- Figur 4: zeigt eine Anordnung zum Testen eines Lastabwurfs, die erfindungsgemäß betrieben werden kann, in schematischer Darstellung.
- Figur 5: zeigt Strom- und Spannungsverläufe an einem aktiven Brückengleichrichter, der gemäß dem Stand der Technik angesteuert wird.
- Figur 6: zeigt Strom- und Spannungsverläufe an einem aktiven Brückengleichrichter, der gemäß einer Ausführungsform der Erfindung angesteuert wird.
- Figur 7: zeigt eine Schaltung zur Ansteuerung eines aktiven Schaltelements gemäß einer Ausführungsform der Erfindung.

In den Figuren sind gleiche oder einander entsprechende Elemente mit gleichen Bezugszeichen angegeben. Auf eine wiederholte Erläuterung wird verzichtet.

### Ausführungsform(en) der Erfindung

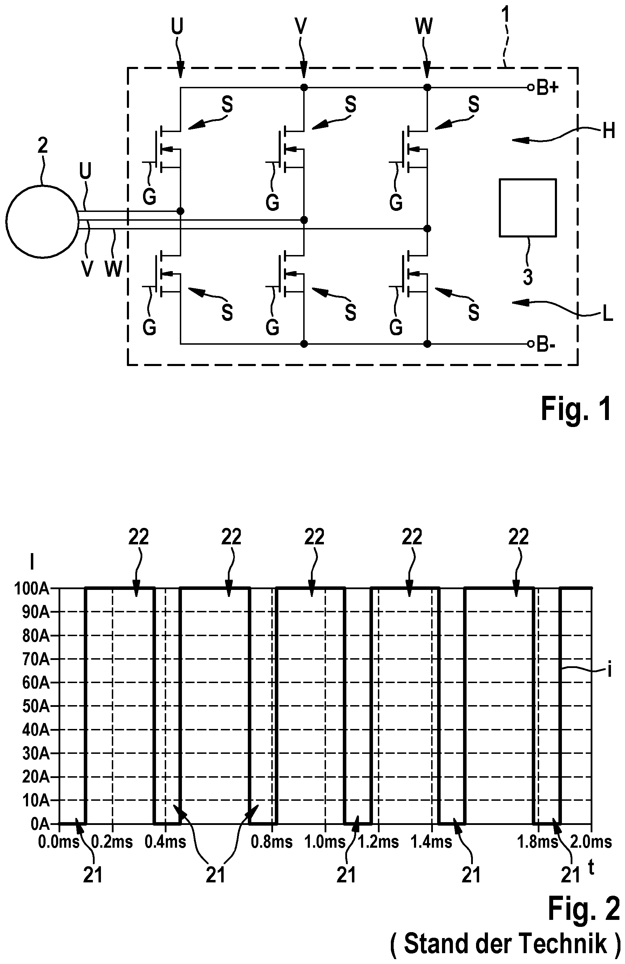

In Figur 1 ist eine Anordnung mit einem Brückengleichrichter 1 und einem Generator 2 am Beispiel eines dreiphasigen Systems schematisch dargestellt. Der Brückengleichrichter 1 kann gemäß einer besonders bevorzugten Ausführungsform der Erfindung angesteuert werden. Er ist in Figur 1 als sechspulsiger Brückengleichrichter dargestellt, der zur Gleichrichtung eines Drehstroms eines dreiphasigen Generators 2 eingerichtet ist. In gleicher Weise kann jedoch beispielsweise auch ein fünf-, sechs- oder siebenphasiger Generator 2 und ein entsprechend angepasster Brückengleichrichter 1 eingesetzt werden.

Der Brückengleichrichter 1 weist drei Halbbrücken U, V und W auf, die über Eingänge u, v und w mit entsprechenden Ausgängen des Generators 2, und damit mit den jeweiligen Generatorwicklungen, verbunden sind.

Die Halbbrücken U, V und W sind ausgangsseitig beispielsweise an einen positiven Batteriepol B+ und einen negativen Batteriepol B- und/oder entsprechende Versorgungsleitungen B+ und B- eines Gleichspannungsnetzes angeschlossen. Der Anschluss B- kann mit Masse verbunden sein. Die Halbbrücken U, V und W weisen jeweils aktive Schaltelemente S, beispielsweise MOSFETs, auf, die jeweils in einen oberen Zweig H und einen unteren Zweig L der jeweiligen Halbbrücken U, V, und W eingebunden sind.

Ein Eingang u, v und w kann nach Maßgabe einer entsprechenden Beschaltung der aktiven Schaltelemente S mit B+ und/oder B- verbunden werden, wobei eine gleichzeitige Ansteuerung beider Schaltelemente einer Halbbrücke U, V und W zu vermeiden ist, um "heiße Pfade" zwischen B+ und B- zu verhindern.

Die aktiven Schaltelemente S können über ihre jeweiligen Gate-Anschlüsse G mit einem durch eine Steuereinrichtung 3 über nicht dargestellte Ansteuerleitungen entsprechend einem Ansteuermuster bereitgestellten Ansteuersignal beaufschlagt werden. Der Normalbetrieb des Generators umfasst, die aktiven Schaltelemente S derart anzusteuern, dass ein an einem entsprechenden Eingang u, v und w anliegendes Stromsignal einer damit verbundenen Generatorwicklung des Generators 2 abwechselnd nach B+ und B- durchgesteuert wird. Regelhaft erfolgt dies derart, dass bei Anliegen einer positiven Halbwelle an den Eingängen u, v und w das jeweilige Signal nach B+, bei Anliegen einer negativen Halbwelle das Signal hingegen nach B- durchgesteuert wird. Die Einstellung einer Ausgangsspannung an B+ kann auch durch eine entsprechende Taktung erfolgen.

Ein Lastabwurf kann in einer in Figur 1 dargestellten Anordnung auf Grundlage eine an B+ anliegenden Spannung detektiert werden. Wenn hierbei ein definierter Schwellwert überschritten wird, kann auf einen Lastabwurf erkannt werden.

Die Ansteuerung des Gleichrichters 1 bei einem erkannten Lastabwurf kann derart erfolgen, dass wenigstens eine der Phasenwicklungen des Generators 2, die jeweils über einen der Eingänge u, v und w mit den Halbbrücken des Gleichrichters 1 verbunden ist, zeitlich definiert mit B-, also beispielsweise mit Masse, verbunden wird. Dies wird auch als "Kurzschließen" bezeichnet. In der Folge sinkt die Spannung ab. Wird der Masseschluss wieder unterbrochen (der jeweilige Kurzschluss also gelöst), steigt die Spannung wieder an. Dieser Ablauf kann zur Regelung der Ausgangsspannung und/oder zum Abbau einer Überspannung des Generators verwendet werden. Wie erwähnt, können hierbei jedoch Probleme durch Strom- bzw. Spannungsspitzen auftreten, weil ein entsprechender Strom schlagartig auf- bzw. abgebaut wird. Durch die Spannungsspitzen werden hohe Verlustleistungen in den Halbbrücken erzeugt, die zu einer thermischen Zerstörung führen können. Eine entsprechende Regelung mit hochfrequenter Taktung eines entsprechenden Ansteuersignals ist aufwendig und verursacht ggf. Probleme hinsichtlich der elektromagnetischen Verträglichkeit.

Auch kann spezifisch beispielsweise jeweils genau ein Eingang u, v und w des Gleichrichters 1 während des Zeitraums des Anliegens einer vollständigen positiven Halbwelle aus einer an diesem Eingang angeschlossenen Phasenwicklung mit B- und gleichzeitig oder alternativ dazu jeweils genau einen Eingang u, v und w des Gleichrichters 1 während des Zeitraums des Anliegens einer vollständigen negativen Halbwelle aus einer an diesem Eingang angeschlossenen Phasenwicklung mit B+ verbunden werden. Auch hierbei ergibt sich jedoch das Problem der möglicherweise auftretenden Strom- bzw. Spannungsspitzen.

In Figur 2 ist ein Generatorstromverlauf bei einer derartigen Ansteuerung eines aktiven Brückengleichrichters 1 bei Lastabwurf gemäß dem Stand der Technik dargestellt. In dem in Figur 2 dargestellten Diagramm ist der Generatorstromverlauf i als Strom I in A auf der y-Achse gegen eine Zeit t in ms auf der x-Achse aufgetragen.

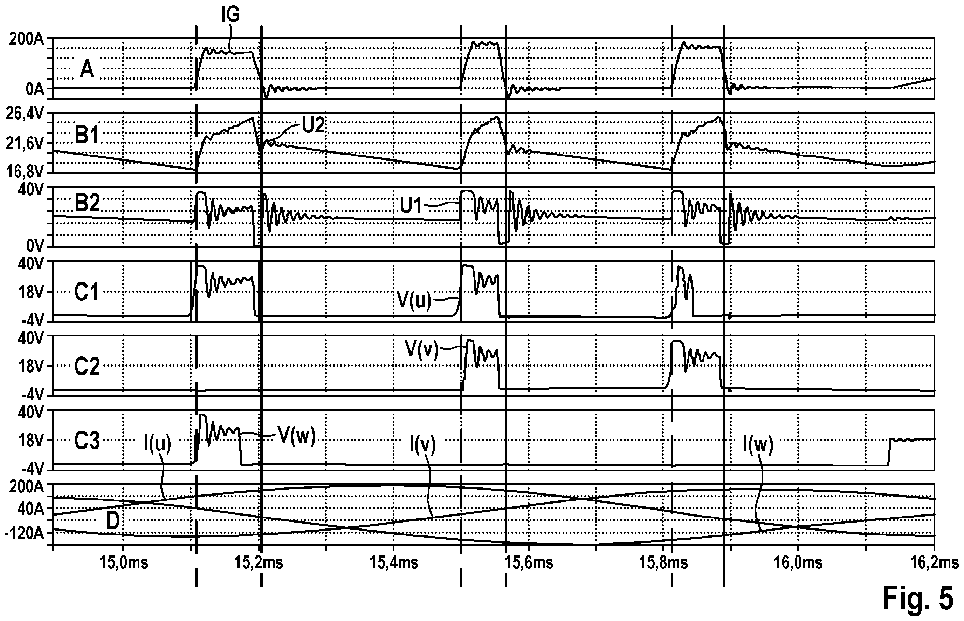

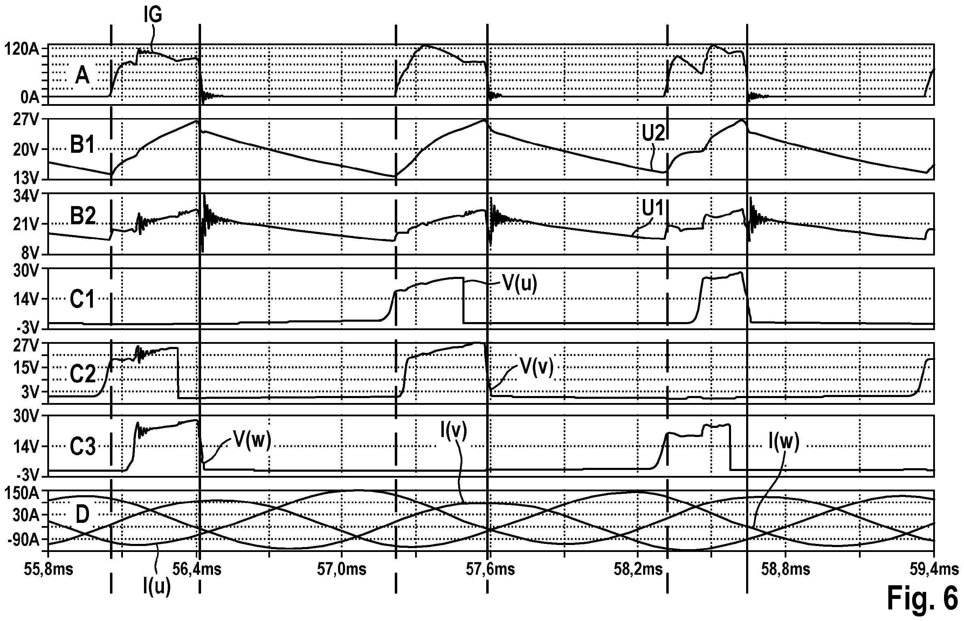

Wie bereits im Zusammenhang mit Figur 1 erläutert, werden im Rahmen einer herkömmlichen Ansteuerung bei Lastabwurf die Schaltelemente S während bestimmter Zeiträume 21 beispielsweise gegen B- kurzgeschlossen. Während der Zeiträume 22 wird ein Strom hingegen in das Gleichspannungsnetz abgegeben. Wie ersichtlich, erhöht sich der Strom dabei schlagartig von beispielsweise 0 A auf 100 A und reduziert sich entsprechend schlagartig. Hierdurch können in Verbindung mit Leitungsinduktivitäten im Bordnetz, wie erläutert, Spannungsspitzen mit entsprechend negativen Effekten entstehen. Dies kann erfindungsgemäß vermieden werden, weil durch die entsprechend verlängerte Schaltzeit der Stromverlauf flachere Signalflanken aufweist. Dies ermöglicht, mit anderen Worten, eine "weiche" Übernahme des Stroms aus den Leitungsinduktivitäten in die Schaltelemente bzw. umgekehrt. Die entsprechend einer Ausführungsform der Erfindung erzielbaren Verbesserungen sind aus den unten erläuterten Figuren 5 und 6, insbesondere den dortigen Teildiagrammen A, ersichtlich.

In Figur 3 sind Kennlinien 31, 32 und 33 eines gemäß einer Ausführungsform der Erfindung ansteuerbaren aktiven Schaltelements für einen Brückengleichrichter dargestellt. Beispielsweise handelt es sich hierbei um Kennlinien 31, 32 und 33 eines Schaltelements S des in Figur 1 dargestellten Brückengleichrichters 1, beispielsweise eines entsprechenden MOSFETs.

Auf der x-Achse ist eine Spannung zwischen Gate und Source des aktiven Schaltelements, also beispielsweise ein Spannungswert eines zur Ansteuerung eines aktiven Schaltelements S verwendeten Ansteuersignals einer Steuereinrichtung 3, angegeben. Die y-Achse gibt den sich hierdurch ergebenden Durchlasswiderstand in mΩ an. Die Kennlinien 31, 32 und 33 betreffen einen Stromfluss von 21, 52 bzw. 82 A.

Wie ersichtlich, kommt es bei einer Spannung zwischen Gate und Source des Schaltelements von ca. 5 V bis 6 V zu einem drastischen Einbruch des Durchlasswiderstands auf ca. 3 mΩ (sogenannte Schwellenspannung) Allerdings wird hier zunächst noch nicht der Minimalwert von ca. 1,8 mΩ erreicht. In dem gestrichelt dargestellten Bereich 34, der ca. 2 V umfasst, kann daher der Durchlasswiderstand durch eine Anpassung der zwischen Gate und Source anliegenden Spannung beeinflusst werden. Wird dieser Bereich von beispielsweise 8 V bis 4 V bei Lastabwurf langsam durchlaufen, können die in Figur 2 dargestellten steilen Stromanstiege abgedämpft werden. Vorhandene Leitungsinduktivitäten erhalten damit ausreichend Zeit, um eine entsprechende Pufferwirkung zu entfalten. Somit werden keine schädliche Über- oder Unterspannungen mehr erzeugt.

Figur 4 zeigt eine Anordnung 40 zum Testen bzw. Simulieren eines Lastabwurfs, die erfindungsgemäß verwendet werden kann, in schematischer Darstellung. Die Anordnung 40 umfasst einen Generator 2 wie zuvor unter Bezugnahme auf Figur 1 erläutert. An diesem liegt eine Spannung U1 an.

Die Kondensatoren 41 und 42 und die Lastwiderstände 43 und 44 der Anordnung 40 repräsentieren Kapazitäten bzw. Widerstände eines realen Bordnetzes. An diesen fällt eine Spannung U2 ab. Sie sind über eine Leitung 47 an den Generator 2 angebunden und über Schalter 45 und 46 schaltbar. Die Leitung 47 bildet die Induktivität des Fahrzeug-Bordnetzes nach, aufgrund derer sich im Fall eines Lastabwurfs ein Spannungsunterschied zwischen U1 und U2 einstellt.

Zu Beginn eines Lastabwurftests sind beide Schalter 45 und 46 geschlossen. Der Generator 2 gibt einen Strom an das Bordnetz ab, der sich aus der Spannung U2 und den Lastwiderständen 43 und 44 errechnet.

Ein Lastabwurf kann durch das Öffnen eines der Schalter 45 bzw. 46 nachgebildet. Das Öffnen des Schalters 45 entspricht dabei einem Lastabfall auf 0%, wie er in der Realität beispielsweise durch den Abfall des Batteriebolzens am Generator verursacht würde. Das Öffnen des Schalters 46 bildet dagegen einen teilweisen Lastabfall nach, wie er durch die Abschaltung einer größeren resistiven Last im Bordnetz verursacht wird. Die Höhe des "abgeworfenen" Laststroms lässt sich durch den Widerstandswert des Lastwiderstands 44 einstellen, die Höhe des restlichen Bordnetzstroms durch den Widerstandswert des Lastwiderstands 43.

Zu beachten ist, dass aufgrund der impulsförmigen Stromabgabe des Generators (siehe Figur 2) zur kontinuierlichen Spannungsversorgung des Gleichspannungsnetzes ein Energiespeicher, beispielsweise in Form eines Kondensators erforderlich ist. Dies ist in üblichen Gleichspannungsnetzen, beispielsweise Kraftfahrzeugbordnetzen, immer der Fall. Bei der Unterbrechung der erläuterten Phasenkurzschlüsse kommt es aufgrund der Leitungsinduktivitäten aber zu einer Spannungserhöhung.

Die Figuren 5 und 6 zeigen Strom- und Spannungsverläufe an einem aktiven Brückengleichrichter, der gemäß dem Stand der Technik (Figur 5) und gemäß einer Ausführungsform der Erfindung (Figur 6) angesteuert wird. Es handelt sich hierbei um einen dreiphasigen Generator mit einem entsprechenden Gleichrichter, wie er beispielsweise in der Anordnung der Figur 1 dargestellt ist. Die Strom- und Spannungsverläufe sind jeweils in A bzw. V auf den jeweiligen y-Achsen der Teildiagramme A bis D gegenüber einer Zeit in ms auf der gemeinsamen x-Achse angegeben. Die Figuren 5 und 6 werden anhand von Strömen und Spannungen, wie sie in einer in Figur 4 dargestellten Anordnung auftreten, veranschaulicht. Entsprechende Ströme und Spannungen treten jedoch in ähnlicher Weise in realen Lastabwurfssituationen auf.

Mit senkrechten, durchgezogenen Linien sind jeweils Zeitpunkte bezeichnet, ab denen eine Aktivierung eines Kurzschlusses in den jeweiligen Schaltelementen eingeleitet wird, gestrichelte Linien geben entsprechend die Zeitpunkte an, ab denen damit begonnen wird, den Kurzschluss zu lösen.

Die Teildiagramme A zeigen, mit IG bezeichnet, einen Generatorabgabestrom. Dieser kann beispielsweise in der Anordnung 40 der Figur 4 in der Leitung 47 gemessen werden. In den Teildiagrammen B1 und B2 sind Spannungsverläufe, die den Spannungen U2 und U1 der Figur 4 entsprechen, dargestellt. Die Teildiagramme C1 bis C3 zeigen Phasenspannungen V(u) bis V(w) an den Generatorphasen u bis w des verwendeten dreiphasigen Generators. Die Teildiagramme D zeigen die jeweiligen Phasenströme.

Wie insbesondere aus der Zusammenschau der Teildiagramme B1 und B2 der Figuren 5 und 6 ersichtlich, erreichen insbesondere die Schwankungen in der Spannung U1 im Rahmen der herkömmlichen Ansteuerung (Figur 5) Werte, die für angebaute Elektroniken einen schädlichen Einfluss ausüben können. Dies wird bei der Ansteuerung gemäß der Ausführungsform der Erfindung (Figur 6) vermieden.

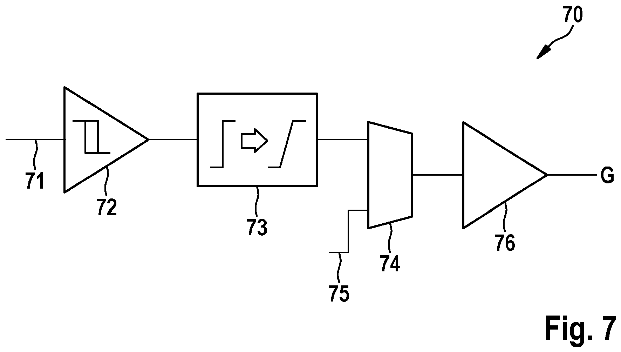

Figur 7 zeigt, insgesamt mit 70 bezeichnet, die schaltungstechnische Umsetzung einer verlangsamten Ansteuerung bei Lastabwurf gemäß einer Ausführungsform der Erfindung.

Über einen Anschluss 71, der beispielsweise mit einem positiven Spannungspol B+ an einem Generatorausgang verbunden ist (vgl. Figur 1), wird eine entsprechende Spannung laufend mittels eines Komparators 72 zur Lastabwurferkennung überwacht. Wird ein Lastabwurf am Anschluss 71 erkannt, wird über den Komparator 72 ein Ausgangssignal ausgegeben.

Eine Rampensteuerung 73 begrenzt auf Grundlage des Ausgangssignals des Komparators 72 die Steilheit einer Signalflanke zur Ansteuerung von Schaltelementen, z.B. der Schaltelemente S der Figur 1, wie mehrfach erläutert.

Eine Priorisierungseinrichtung 74 schaltet für die Dauer des Phasenkurzschlusses das an einem Eingang 75 anliegende reguläre Ansteuersignal ab. Hierdurch wird eine entsprechend verlangsamte Spannungsänderung durch einen Gatetreiber 76 am Gate G des Schaltelements S eingestellt.

## Patentansprüche

1. Verfahren zur Ansteuerung eines Brückengleichrichters (1) mit aktiven Schaltelementen (S), bei dem in einem Normalbetrieb wenigstens eines der aktiven Schaltelemente (S) mit einem Spannungssignal angesteuert wird, dessen Spannung innerhalb wenigstens einer Schaltzeit von einem ersten Spannungswert zu Beginn der Schaltzeit auf einen zweiten Spannungswert zum Ende der Schaltzeit verändert wird, wobei der niedrigere von erstem und zweitem Spannungswert unterhalb einer Schwellenspannung des Schaltelements (S) und der höhere von erstem und zweitem Spannungswert oberhalb der Schwellenspannung des Schaltelements (S) liegt, wobei bei Feststellung eines Lastabwurfs an dem Brückengleichrichter (1) die wenigstens eine Schaltzeit um einen vorgebbaren Zeitraum verlängert wird, sodass eine Steigung des Spannungssignals beim Schalten verringert wird.

2. Verfahren nach Anspruch 1, bei dem durch eine Ansteuerung wenigstens eines aktiven Schaltelements (S) mit unterschiedlichen Spannungswerten zwischen dem ersten und dem zweiten Spannungswert unterschiedliche Widerstandswerte zwischen Schaltanschlüssen (D, O), die durch das aktive Schaltelement (S) schaltbar sind, erzeugt werden können.

3. Verfahren nach Anspruch 2, bei dem eine Ansteuerung des wenigstens einen verwendeten aktiven Schaltelements (S), die eine graduelle Einstellung der Spannungswerte zwischen dem ersten und dem zweiten Spannungswert umfasst, mit einer graduellen Veränderung des Durchlasswiderstands zwischen den Schaltanschlüssen (D, O) in Beziehung steht.

4. Verfahren nach Anspruch 2 oder 3, bei dem als das wenigstens eine aktive Schaltelement (S) wenigstens ein Transistor, insbesondere ein Metall-Oxid-Halbleiter-Feldeffekttransistor, verwendet wird, wobei durch das Spannungssignal ein Gate (G) des wenigstens einen Transistors beaufschlagt wird.

5. Verfahren nach Anspruch 4, bei dem als der erste Spannungswert ein Spannungswert verwendet wird, der unterhalb einer Schwellenspannung des wenigstens einen Transistors liegt und bei dem als der zweite Spannungswert ein Spannungswert verwendet wird, der oberhalb der Schwellenspannung des wenigstens einen Transistors liegt.

6. Verfahren nach einem der vorstehenden Ansprüche, bei dem der Lastabwurf auf Grundlage eines durch den Brückengleichrichter (1) in dem Normalbetrieb ausgegeben Ausgangssignals festgestellt wird.

7. Verfahren nach einem der vorstehenden Ansprüche, bei dem bei der Feststellung des Lastabwurfs ein an einer Halbbrücke (U, V, W) anliegendes Spannungssignal über das wenigstens eine aktive Schaltelement (S) zumindest zeitweise an einen Masseanschluss (B-) abgeleitet wird.

8. Verfahren nach einem der vorstehenden Ansprüche, bei dem der Zeitraum, um den die Schaltzeit verlängert wird, auf Grundlage einer maximal zulässigen Spannungserhöhung und wenigstens eines Induktivitätswerts in einem Netz, das der aktive Brückengleichrichter (1) speist, bestimmt wird.

9. Gleichrichteranordnung mit einem Brückengleichrichter (1) mit aktiven Schaltelementen (S), die zur Durchführung eines Verfahrens nach einem der vorstehenden Ansprüche eingerichtet ist, wobei die Gleichrichteranordnung eine Steuereinrichtung (3),die dafür eingerichtet ist, wenigstens eines der aktiven Schaltelemente (S) mit einem Spannungssignal anzusteuern, dessen Spannung innerhalb wenigstens einer Schaltzeit von einem ersten Spannungswert zu Beginn der Schaltzeit auf einen zweiten Spannungswert zum Ende der Schaltzeit veränderbar ist, wobei der niedrigere von erstem und zweitem Spannungswert unterhalb einer Schwellenspannung des Schaltelements (S) und der höhere von erstem und zweitem Spannungswert oberhalb der Schwellenspannung des Schaltelements (S) liegt, Mittel, die zur Feststellung eines Lastabwurfs an dem Brückengleichrichter (1) eingerichtet sind, und Mittel, die zum Verlängern der wenigstens einen Schaltzeit um einen vorgebbaren Zeitraum bei einem festgestellten Lastabwurf derart eingerichtet sind, so dass eine Steigung des Spannungssignals beim Schalten verringert ist, aufweist.

10. Computerprogramm mit Programmcodemitteln, die eine Recheneinheit, insbesondere eine Steuereinrichtung (3) nach Anspruch 9, dazu veranlassen, ein Verfahren nach einem der Ansprüche 1 bis 8 durchzuführen, wenn sie auf der Recheneinheit ausgeführt werden.

## Claims

1. Method for driving a bridge rectifier (1) having active switching elements (S), wherein, in normal operation, at least one of the active switching elements (S) is driven by a voltage signal, the voltage of which is changed within at least one switching time from a first voltage value at the beginning of the switching time to a second voltage value at the end of the switching time, wherein the lower of the first and second voltage values is below a threshold voltage of the switching element (S) and the higher of the first and second voltage values is above the threshold voltage of the switching element (S), wherein upon detection of a load drop at the bridge rectifier (1) the at least one switching time is extended by a pre-settable period of time so that an increase in the voltage signal during switching is reduced.

2. Method according to claim 1, wherein by driving at least one active switching element (S) with different voltage values between the first and the second voltage value, different resistance values between switching terminals (D, O), which are switchable by the active switching element (S), can be generated.

3. Method according to claim 2, wherein a driving of the at least one active switching element (S) which is used, comprising a gradual adjustment of the voltage values between the first and second voltage values, is related to a gradual variation of the forward resistance between the switching terminals (D, O).

4. Method according to claim 2 or 3, wherein at least one transistor, in particular a metal oxide semiconductor field effect transistor, is used as the at least one active switching element (S), wherein a gate (G) of the at least one transistor is applied by the voltage signal.

5. Method according to claim 4, wherein a voltage value lying below a threshold voltage of the at least one transistor is used as the first voltage value and wherein a voltage value lying above the threshold voltage of the at least one transistor is used as the second voltage value.

6. Method according to any one of the preceding claims, wherein the load drop is determined based on an output signal output by the bridge rectifier (1) in normal operation.

7. Method according to any one of the preceding claims, wherein a voltage signal applied to a half-bridge (U, V, W) is derived at least temporarily to a ground terminal (B-) via the at least one active switching element (S) when the load drop is detected.

8. Method according to any one of the preceding claims, wherein the period of time by which the switching time is extended is determined based on a maximum allowable voltage increase and at least one inductivity value in a network fed by the active bridge rectifier (1).

9. Rectifier arrangement comprising a bridge rectifier (1) having active switching elements (S) configured to perform a method according to any one of the preceding claims, wherein the rectifier arrangement comprises a control device (3) configured to drive at least one of the active switching elements (S) by a voltage signal, the voltage of which is changeable within at least one switching time from a first voltage value at the beginning of the switching time to a second voltage value at the end of the switching time, wherein the lower of the first and second voltage values is below a threshold voltage of the switching element (S) and the higher of the first and second voltage values is above the threshold voltage of the switching element (S), means configured to detect a load drop at the bridge rectifier (1), and means configured to extend the at least one switching time by a pre-settable period of time so that an increase in the voltage signal during switching is reduced when a load drop is detected.

10. Computer program having program code means causing a computing unit, in particular a control device (3) according to claim 9, to perform a method according to any one of claims 1 to 8 when executed on the computing unit.

## Revendications

1. Procédé de commande d'un redresseur en pont (1) avec des éléments de commutation actifs (S), dans lequel, pendant un fonctionnement normal, au moins un des éléments de commutation actifs (S) est commandé avec un signal de tension dont la tension est changée dans les limites d'au moins un temps de commutation depuis une première valeur de tension au début du temps de commutation jusqu'à une seconde valeur de tension à la fin du temps de commutation, dans lequel la plus petite valeur parmi les première et seconde valeurs de tension est inférieure à une tension de seuil de l'élément de commutation (S) et la plus grande valeur parmi les première et seconde valeurs de tension est supérieure à la tension de seuil de l'élément de commutation (S), dans lequel, en cas de détection d'une rupture de charge au niveau du redresseur en pont (1), le au moins un temps de commutation est allongé d'une durée prédéfinie de telle sorte qu'une augmentation du signal de tension est réduite au moment de la commutation.

2. Procédé selon la revendication 1, dans lequel une commande d'au moins un élément de commutation actif (S) avec différentes valeurs de tension entre les première et seconde valeurs de tension permet de générer différentes valeurs de résistance entre des bornes de commutation (D, O) qui peuvent être commutées par l'élément de commutation actif (S).

3. Procédé selon la revendication 2, dans lequel une commande du au moins un élément de commutation actif (S) utilisé, qui comprend un réglage progressif des valeurs de tension entre les première et seconde valeurs de tension, est corrélée à une variation progressive de la résistance thermique entre les bornes de commutation (D, 0).

4. Procédé selon la revendication 2 ou 3, dans lequel au moins un transistor, en particulier un transistor à effet de champ à semi-conducteur d'oxyde métallique, est utilisé en tant qu'au moins un élément de commutation actif (S), dans lequel le signal de tension est appliqué à une porte (G) du au moins un transistor.

5. Procédé selon la revendication 4, dans lequel une valeur de tension est utilisée en tant que première valeur de tension inférieure à une tension de seuil du au moins un transistor, et dans lequel une valeur de tension est utilisée en tant que seconde valeur de tension supérieure à la tension de seuil du au moins un transistor.

6. Procédé selon l'une des revendications précédentes, dans lequel la rupture de charge est détectée sur la base d'un signal de sortie délivré par le redresseur en pont (1) pendant le fonctionnement normal.

7. Procédé selon l'une des revendications précédentes, dans lequel, en cas de détection de la rupture de charge, un signal de tension présent au niveau d'un demi-pont (U, V, W) est dévié, au moins temporairement, vers une borne de masse (B-) par le moins un élément de commutation actif (S).

8. Procédé selon l'une des revendications précédentes, dans lequel la durée d'allongement du temps de commutation est déterminée sur la base d'une augmentation de tension admissible maximale et d'au moins une valeur d'inductance dans un réseau qui alimente le redresseur en pont actif (1).

9. Système de redresseur comportant un redresseur en pont (1) avec des éléments de commutation actifs (S), qui est configuré pour mettre en œuvre un procédé selon l'une des revendications précédentes, dans lequel le système de redresseur comporte un dispositif de commande (3) configuré pour commander au moins un des éléments de commutation actifs (S) avec un signal de tension dont la tension peut être changée dans les limites d'au moins un temps de commutation depuis une première valeur de tension au début du temps de commutation jusqu'à une seconde valeur de tension à la fin du temps de commutation, dans lequel la plus petite valeur entre les première et seconde valeurs de tension est inférieure à une tension de seuil de l'élément de commutation (S) et la plus grande valeur entre les première et seconde valeurs de tension est supérieure à la tension de seuil de l'élément de commutation (S), des moyens configurés pour détecter une rupture de charge sur le redresseur en pont (1), et des moyens configurés pour allonger le au moins un temps de commutation d'une durée pouvant être prédéfinie en cas de rupture de charge détectée, de telle sorte qu'une augmentation du signal de tension est réduite lors de la commutation.

10. Programme informatique ayant des moyens de code de programme qui permettent à une unité de calcul, en particulier un dispositif de commande (3) selon la revendication 9, de mettre en œuvre un procédé selon l'une des revendications 1 à 8, lorsqu'ils sont exécutés sur l'unité de calcul.
